# EUROPEAN PATENT SPECIFICATION

(11) **EP 1 892 828 B1**
(45) Date of publication and mention of the grant of the patent: **04.11.2009**
(21) Application number: 07115022.1
(22) Date of filing: 27.08.2007
(51) Int. Cl.: H03F 1/30

(54) **Device for preventing a pop noise in an audio output apparatus and method therefor**
Vorrichtung zur Verhinderung von Knackgeräuschen in einer Audioausgabevorrichtung und Verfahren dafür
Dispositif pour empêcher un bruit transitoire dans un appareil de sortie audio et procédé correspondant

(30) Priority: 25.08.2006 KR 20060081353
(43) Date of publication of application: 27.02.2008
(73) Proprietor: Samsung Electronics Co., Ltd., Suwon-si, Gyeonggi-do (KR)
(72) Inventor: Jung, Byeng-Sang, c/o Samsung Electr. Co., Ltd., Gyeonggi-do (KR); Kim, Hark-Soo, c/o Samsung Electr. Co., Ltd., Gyeonggi-do (KR)
(74) Representative: Grünecker, Kinkeldey, Stockmair & Schwanhäusser Anwaltssozietät

(56) References cited:
- WO-A-2005/104349
- JP-A- 2003 332 848
- US-A1- 2007 279 101
- US-B1- 6 600 365
- US-B2- 6 573 787
- US-B2- 6 774 684
- US-B2- 7 084 701

## Description

### BACKGROUND OF THE INVENTION

### 1. Field of the Invention

The present invention relates generally to an audio output apparatus, and in particular, to a device for preventing the pop noise induced in an audio output apparatus and method therefor.

### 2. Description of the Related Art

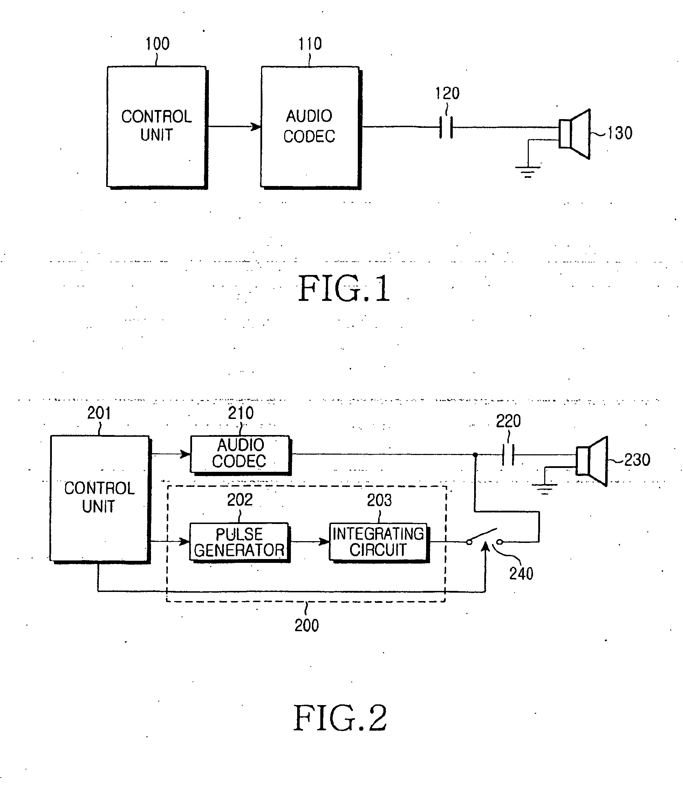

An audio output apparatus generally includes, as shown in Fig. 1, a control unit 100, an audio codec (coder/decoder) 110, a capacitor 120, and a speaker 130. The audio codec 110 is driven by the control unit 100 for decoding sound data into corresponding analog sound signals.

The audio codec 110 upon activation turns on the amplifier arranged at the output end thereof so as to cause a bias voltage of the amplifier to abruptly rise. The abrupt, rising of the bias voltage generates an alternate current that is applied through the capacitor 120 to the speaker 130, thereby causing a pop noise.
Meanwhile, such bias voltage is stored in the capacitor 120 so that it is not discharged during the operation of the audio codec 110 because there is no discharging path. However, if the audio codec is turned off, a discharging path is formed from the capacitor 120 to the audio codec 110 for discharging the capacitor 120. Consequently, whenever the audio codec 110 is activated, the bias voltage is newly charged, thus causing the pop noise. Recently, such pop noise causes a new problem in the sound source mounted in the mobile communication terminal that has been developed to have enhanced multimedia function.

US -B2- 7 084 701 discloses an audio amplifier circuitry that produces reduced "pop" noise in speakers such as in handsfree headsets. US -82- 6 774 684 discloses a circuitry for controlling transients during audio device power-up and power-down that selectively decouples a first driver from load during a ramping up mode and couples first driver to load during a normal operating mode. US -B1- 6 600 365 discloses an audio transient suppression circuit comprising an active signal processing stage having an output node, the output node having a dc signal path to a first dc voltage, said dc signal path including at least one first resistive element. The circuit further comprises an output signal transient suppresser, said transient suppresser comprising a second resistive element switchably connected between a second dc voltage and said output node. US -B2- 6 573 787 discloses an audio amplifier circuit comprising: a voltage-gain amplifier and a current-gain amplifier in series thereafter between an input node and an output node; power supply lines for supplying power to the audio amplifier circuit; an outer negative feedback loop around the current-gain amplifier and the voltage-gain amplifier; an inner negative feedback loop around the voltage-gain amplifier; a first switch for selectively connecting the power supply lines to the current-gain amplifier; a second switch for selectively switching the inner negative feedback loop or the outer feedback loop to the voltage-gain amplifier; and a control circuit arranged to control the switch during power supply switching. In JP 2003 332848 A it is described a p noise prevention circuit with a voltage source circuit that operates when the power is supplied and generates a medium voltage while the voltage of a coupling capacitor reaches the center voltage of a PWM signal, and an analog switch circuit that gradually reduces the internal resistance when the power is supplied and supplies the voltage generated by the voltage source circuit to the coupling capacitor. WO 2005/104349 A discloses a gnal output circuit wherein noise is prevented from occurring upon a power-up and a power-down by a selecting circuit that selectively outputs a non-significant PWM signal NSPWM or a significant PWM signal SPWM in accordance with a power supply transition period or a normal period. A non-significant signal generating circuit generates a gradually rising signal, which is then amplified by a second driver circuit, whereby a DC block capacitor is gradually charged and discharged, thereby preventing noise from occurring due to an inrush current.

### SUMMARY OF THE INVENTION

It is, therefore, an object of the present invention to provide a device and method for preventing the pop noise induced when activating the audio codec.

The present invention provides a device for preventing an audio pop noise acccording to claim 1 and, alternatively, claim 2.

### BRIEF DESCRIPTION OF THE DRAWINGS

the above and other objects, features and advantages of the present invention will become more apparent from the following detailed description when taken in conjunction with the accompanying drawing in which:
FIG 1 is a block diagram for illustrating the circuit of the conventional audio output apparatus;
FIG 2 is a block diagram illustrating a circuit of an audio output apparatus for preventing the pop noise according to the present invention;
FIGS. 3A and 3B are graphs illustrating the charging time of a capacitor varying with the pulse width of the Pulse Width Modulation (PWM) pulse signals according to the present invention;
FIGS. 4A and 4B are graphs illustrating the charging time of a capacitor varying with the pulse density of the Pulse Density Modulation (PDM) pulse signals according to the present invention; and
FIG 5 is a flowchart illustrating a process of the audio output apparatus preventing the pop noise according to the present invention.

### DETAILED DESCRIPTION OF THE PREFERRED EMBODIMENT

Preferred embodiments of the present invention will be described herein below with reference to the accompanying drawings. In the drawings, the same or similar elements are denoted by the same reference numerals even though they are depicted in different drawings. In the following description, well-known functions or constructions are not described in detail since they would obscure the invention in unnecessary detail.

The invention provides an audio output apparatus having an audio codec for generating audio signals delivered through a capacitor to a speaker, which smoothly charges the capacitor to have the same voltage level as the bias voltage of the audio codec before activating the audio codec, so that the voltage difference between the capacitor and the bias voltage of the audio codec occurring when activating the audio codec is substantially eliminated, thereby preventing the audio pop noise.

Referring to Fig. 2, the inventive device for preventing the pop noise in an audio output apparatus includes a capacitor charger 200, a control unit 201, an audio codec 210, a capacitor 220, a speaker 230, and a switch 240. The capacitor charger 200 is driven by the control unit 201 for charging the capacitor 220 through the switch 240. The capacitor charger 200 includes a pulse generator 202 and an integrating circuit 203.

The pulse generator 202 generates a predetermined pulse signal under the control of the control unit 201. The pulse generator 202 generates a pulse signal , which may be one of a Pulse Density Modulation (PDM) pulse signal and a Pulse Width Modulation (PWM) pulse signal. The integrating circuit 203 integrates the pulse signals from the pulse generator 202 for producing a capacitor charge voltage for charging the capacitor 220. The control unit 201 drives the capacitor charger 200 and turns on the switch 240 before activating the audio codec 210 for controlling all of the functions of the audio output apparatus so as to prevent the pop noise.
The audio codec 210 converts the digital audio data into the corresponding analog audio signals while adjusting and amplifying the magnitude of the analog audio signals. The audio signals outputted from the audio codec 210 are delivered to the speaker 230.

The switch 240 is connected between the junction of the output end of the audio codec 210 and the capacitor 220 and the integrating circuit 203, so that it turns on the charging path between the integrating circuit 203 and the capacitor 220, and turns off the charging path to prevent the charged capacitor 220 from being discharged to the integrating circuit 203.

However, it should be noted that where the capacitor 220 is rapidly charged to the equivalent level of the bias voltage of the audio codec 210 before activating the audio codec 210, the same pop noise caused by the bias voltage of the audio codec 210 may occur. In order to eliminate this problem, it is necessary to determine the charging time taken for smoothly charging the capacitor. This charging time may be determined by simulation in the course of designing the inventive audio output apparatus. The charging time also may vary with a pulse signal predetermined for smoothly charging the capacitor 220.

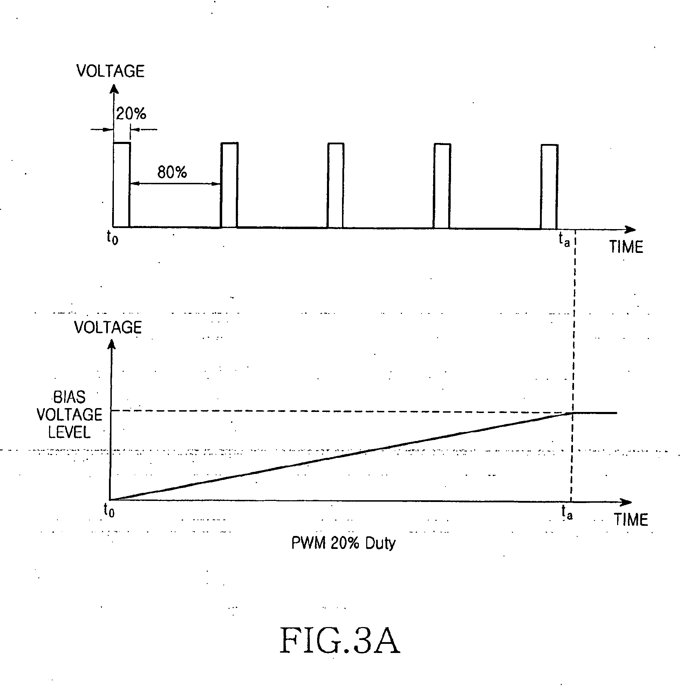

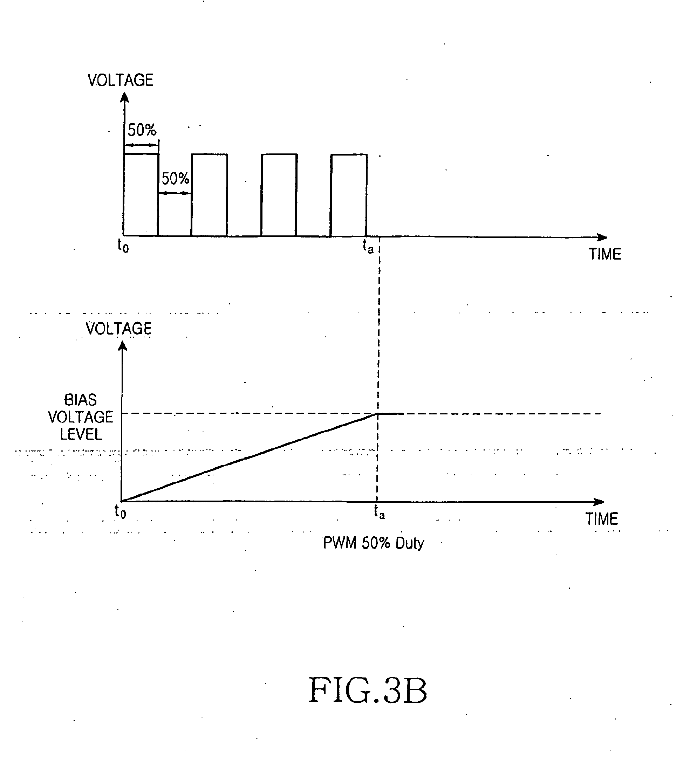

Hereinafter described in connection with Figs. 3A and 3B is the charging time of the capacitor 220 varying with the pulse width of the Pulse Width Modulation (PWM) signal. In this case, Fig. 3A shows the pulse width of the PWM pulse signal rated 20%, and Fig. 3B shows the pulse width of the PWM pulse signal rated 50%.

Referring to Fig. 3A, if the pulse generator 202 generates the PWM pulse signals with the pulse width rated 20% applied to the integrating circuit 203, the time taken for charging the capacitor 220 to the bias voltage level is tₐ as shown by the below graph. However, referring to Fig. 3B, if the pulse width is rated 50%, the charging time tₐ becomes much shorter compared to the case of the pulse width rated 20%. Thus, the time tₐ taken for charging the capacitor varies with the pulse width of the predetermined PWM pulse. Therefore, it is desired to properly adjust the pulse width to be in a range for preventing the pop noise caused by the abrupt charging of the capacitor 220 when there is a predetermined PWM pulse signal. Understandably, the predetermined pulse signal also serves to predetermine the charging time tₐ.

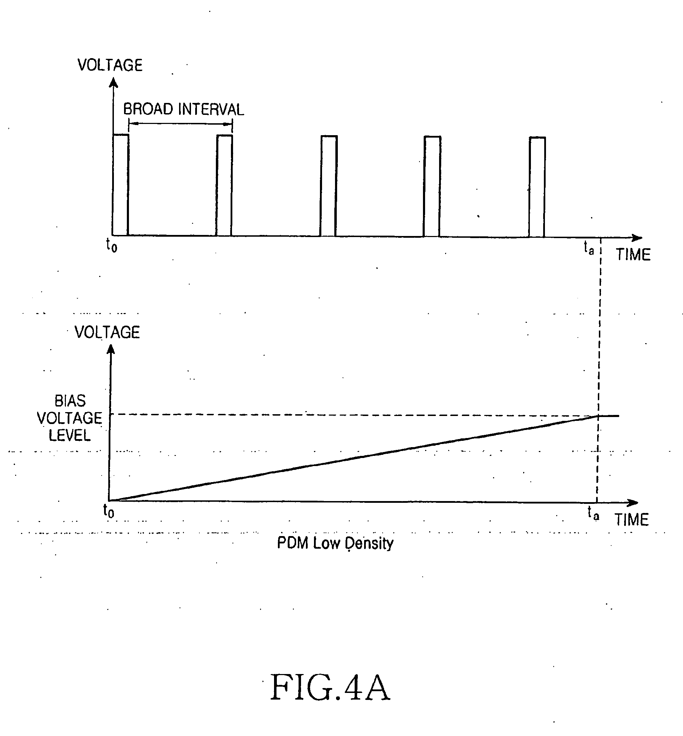

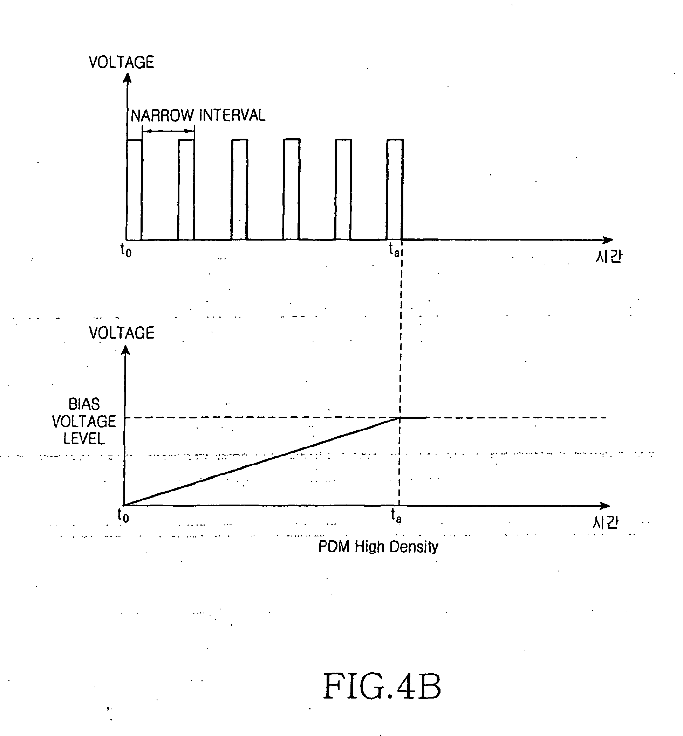

Alternatively, the pulse signal generator 202 may be designed to generate the PDM pulse signal instead of the PWM pulse signal, as shown in Fig. 4A and 4B. Hereinafter described in connection with Figs. 4A and 4B is the charging time of the capacitor 220 varying with the pulse density, wherein Fig. 4A shows the case of low pulse density, and Fig. 4B shows the case of high pulse density. As shown in the drawings, the time tₐ taken for charging the capacitor 220 to the bias voltage level varies with the pulse density. Therefore, it is also desired, as in the case of the PWM pulse, to properly adjust the pulse density to be in the range for preventing the pop noise caused by the abrupt charging of the capacitor 220 when there is a predetermined PDM pulse signal. Understandably, the pulse width of the PWM signal and the pulse density of the PDM signal may be arbitrarily changed considering the charging time within the range for preventing the pop noise.

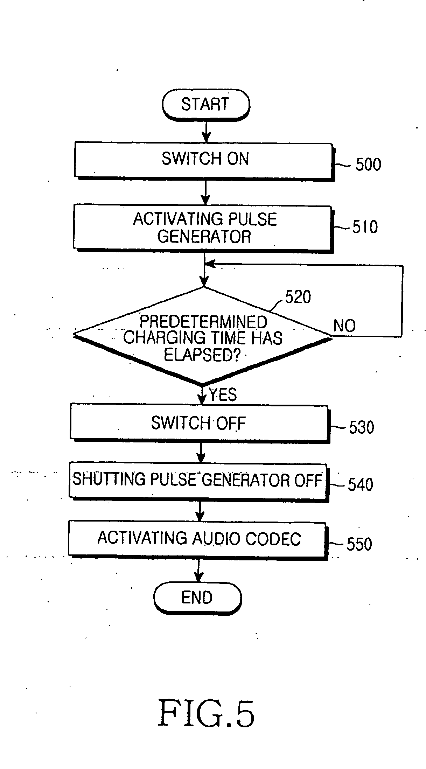

Fig. 5 is a flowchart for illustrating the process of controlling the audio output apparatus for preventing the pop noise, wherein the pulse generator 202 is assumed to generate the PWM pulse signal. In step 500, the control unit 201 turns on the switch 240 before activating the audio codec 210, then proceeds to step 510 to activate the pulse generator 202.

The pulse generator 202 being activated in the step 510, it generates predetermined PWM pulse signals that are applied to the integrating circuit 203, which in turn integrates the pulse signals to produce the charging voltage delivered to the capacitor 220. Then the control unit 201 proceeds to step 520 to determine if a predetermined charging time has elapsed. Here, the predetermined charging time is the time taken for charging the capacitor 220 to the bias voltage level of the audio codec 210. More specifically describing in connection with Figs. 3A and 3B, the predetermined time tₐ varies with the predetermined PWM pulse signal.

If the predetermined time has not elapsed, the control unit 201 repeats the step 520. Then the predetermined time having elapsed, the control unit proceeds to step 530 to turn off the switch 240. The switch 240 being turned off, the charging path between the integrating circuit 203 and the capacitor 220 is cut off for preventing the capacitor 220 from being discharged towards the integrating circuit 203. Then the control unit 201 proceeds to step 540 to shut off the pulse generator 202, and then to step 550 to activate the audio codec 210.

As described above, the inventive device prevents the pop noise caused by the abrupt Direct Current (DC) changes upon activating the audio codec 210 by smoothly charging the capacitor 220 to the bias voltage level of the audio codec 210 prior to activating the audio codec. Namely, the pre-charged capacitor prevents the abrupt DC changes of the bias voltage, and thus the pop noise.

In the present invention, the pulse generator generates the pulse signals with the same value until being shut off, but the pulse signals may be arbitrarily changed to have different values provided that the abrupt rise of the charging voltage level does not induce the pop noise.

While the invention has been shown and described with reference to a certain preferred embodiment thereof, it will be understood by those skilled in the art that various changes in form and details may be made therein without departing from the scope of the invention as described in the appended claims.

## Claims

1. A device for preventing an audio pop noise caused by a bias voltage output from audio codes (210), comprising:
a capacitor (220) connected between the output end of the audio codec (210) and a speaker,
a capacitor charger for smoothly charging the capacitor (220) to a predetermined voltage level;
a switch arranged between the junction of the output end of the audio coded (210) and the capacitor (220) and the capacitor charger; and
a control unit (201) for controlling the codec (210), wherein the control unit (201) turns on the switch and drives the capacitor charger before activating the audio codec (210), and then turns off the switch and terminates the operation of the capacitor charger if a predetermined charging time has elapsed;
**characterized in that**
the capacitor charger comprises
a pulse generator (202) driven by the control unit (201) for generating Pulse Width Modulation (PWM) pulse signals with a pulse width predetermined according to the predetermined charging time; and
an integrating circuit (203) connected between the pulse generator (202) and the switch for integrating the PWM pulse signals so as to charge said capacitor (220).

2. A device for preventing an audio pop noise caused by a bias voltage output from audio codec (210), comprising:
a capacitor (220) connected between the output end of the audio codec (210) and a speaker:
a capacitor charger for smoothly charging the capacitor (220) to a predetermined voltage level;
a switch arranged between the Junction of the output end of the audio codec (210) and the capacitor (220) and the capacitor charger, and
a control unit (201) for controlling the codec (210), wherein the control unit (201) turns on the switch and drives the capacitor charger before activating the audio codec (210), and then turns off the switch and terminates the operation of the capacitor charger if a predetermined charging time has elapsed;
**characterized in that**
the capacitor charger comprises
a pulse generator (202) driven by the control unit (201) for generating Pulse Density Modulation (PDM) pulse signals with a pulse density predetermined according to the predetermined charging time; and
an integrating circuit (203) connected between the pulse generator (202) and said switch for integrating the PDM pulse signals so as to charge the capacitor (220).

3. A device as defined in Claim 1, wherein the predetermined charging time is the time to charge the capacitor (220) to a level of the bias voltage of said audio codec (210).

4. A method for preventing an audio pop noise caused by a bias voltage output from an audio codec (210) generating audio signals delivered through a capacitor (220) to a speaker, comprising the steps of:
smoothly charging the capacitor (220) to have the same voltage level as the bias Voltage of the audio codec (210) before activating the audio codec (210); and
activating the audio codec (210);
**characterized by** that
the step of charging the capacitor (220) comprises
generating Pulse Width Modulation (PWM) pulse signals with a pulse width predetermined according to a predetermined charging time by a pulse generator (202) driven by the control unit (201); and
integrating the PWM pulse signals by an integrating circuit (203) so as to charge said capacitor (220).

5. A method for preventing an audio pop noise caused by a bias voltage output from an audio codec (210) generating audio signals delivered through a capacitor (220) to a speaker, comprising the steps of:
smoothly charging the capacitor (220) to have the same voltage level as the bias voltage of the audio codec (210) before activating the audio codec (210); and
activating the audio codec (210);
**characterized by** that
the step of charging the capacitor (220) comprises
generating Pulse Density Modulation (PDM) pulse signals with a pulse density predetermined according to the predetermined charging time by a pulse generator (202) driven by a control unit (201); and
integrating the PDM pulse signals by an integrating circuit (203) connected between the pulse generator (202) and said switch for so as to charge the capacitor (220).

## Patentansprüche

1. Eine Vorrichtung zum Verhindern von einem Audio-Pop-Geräusch, das durch eine Vorspannung verursacht wird, die von einem Audio-Codec (210) ausgegeben wird, die umfasst:
einen Kondensator (220), der zwischen dem Ausgangsende des Audio-Codecs (210) und einem Lautsprecher angeschlossen ist;
eine Kondensatorladeeinrichtung zum gleichmäßigen Laden des Kondensators (220) bis zu einem vorbestimmten Spannungsniveau;
einen Schalter, der zwischen der Verbindung des Ausgangsendes des Audio-Codecs (210) und dem Kondensator (220) und der Kondensatorladeeinrichtung angeordnet ist; und
eine Steuereinheit (201) zum Steuern des Codecs (210), wobei die Steuereinheit (201) vor dem Aktivieren des Audio-Codecs (210) den Schalter einschaltet und die Kondensatorladeeinrichtung betreibt und dann, wenn eine vorbestimmte Ladezeit vergangen ist, den Schalter ausschaltet und den Betrieb der Kondensatorladeeinrichtung beendet;
**dadurch gekennzeichnet, dass**
die Kondensatorladeeinrichtung umfasst
einen Pulsgenerator (202) zum Erzeugen von Pulsbreitenmodulations (PWM) - Pulssignalen mit einer Pulsbreite, die gemäß der vorbestimmten Ladezeit vorbestimmt ist, und der von der Steuereinheit (201) betrieben wird; und
eine Integrierschaltung (203) zum Integrieren der PWM - Pulssignale, um den genannten Kondensator (220) zu laden, und die zwischen dem Pulsgenerator (202) und dem Schalter angeschlossen ist.

2. Eine Vorrichtung zum Verhindern von einem Audio-Pop-Geräusch, das durch eine Vorspannung verursacht wird, die von einem Audio-Codec (210) ausgegeben wird, die umfasst:
einen Kondensator (220), der zwischen dem Ausgangsende des Audio-Codecs (210) und einem Lautsprecher angeschlossen ist;
eine Kondensatorladeeinrichtung zum gleichmäßigen Laden des Kondensators (220) bis zu einem vorbestimmten Spannungsniveau;
einen Schalter, der zwischen der Verbindung des Ausgangsendes des Audio-Codecs (210) und dem Kondensator (220) und der Kondensatorladeeinrichtung angeordnet ist; und
eine Steuereinheit (201) zum Steuern des Codecs (210), wobei die Steuereinheit (201) vor dem Aktivieren des Audio-Codecs (210) den Schalter einschaltet und die Kondensatorladeeinrichtung betreibt und dann, wenn eine vorbestimmte Ladezeit vergangen ist, den Schalter ausschaltet und den Betrieb der Kondensatorladeeinrichtung beendet;
**dadurch gekennzeichnet, dass**
die Kondensatorladeeinrichtung umfasst
einen Pulsgenerator (202) zum Erzeugen von Pulsdichtemodulations (PWD) - Pulssignalen mit einer Pulsdichte, die gemäß der vorbestimmten Ladezeit vorbestimmt ist, und der von der Steuereinheit (201) betrieben wird; und
eine Integrierschaltung (203) zum Integrieren der PDM - Pulssignale, um den genannten Kondensator (220) zu laden, und die zwischen dem Pulsgenerator (202) und dem genannten Schalter angeschlossen ist.

3. Eine Vorrichtung, wie sie in Anspruch 1 definiert ist, in der die vorbestimmte Ladezeit die Zeit zum Laden des Kondensators (220) bis auf ein Niveau der Vorspannung des genannten Audio-Codecs (210) ist.

4. Ein Verfahren zum Verhindern von einem Audio-Pop-Geräusch, das durch eine Vorspannung verursacht wird, die von einem Audio-Codec (210) ausgegeben wird, der Audiosignale erzeugt, die durch einen Kondensator (220) an einen Lautsprecher geliefert werden, das die Schritte umfasst:
gleichmäßig Laden des Kondensators (220), so dass er dasselbe Spannungsniveau wie die Vorspannung des Audio-Codecs (210) vor dem Aktivieren des Audio-Codecs (210) besitzt; und
Aktivieren des Audio-Codecs (210);
**dadurch gekennzeichnet, dass**
der Schritt des Ladens des Kondensators (220) umfasst
Erzeugen von Pulsbreitenmodulations (PWM) - Pulssignalen mit einer Pulsbreite, die gemäß einer vorbestimmten Ladezeit vorbestimmt ist, durch einen Pulsgenerator, der von einer Steuereinheit (201) betrieben wird; und
Integrieren der PWM - Pulssignale durch eine Integrierschaltung (203), um den genannten Kondensator (220) zu laden.

5. Ein Verfahren zum Verhindern von einem Audio-Pop-Geräusch, das durch eine Vorspannung verursacht wird, die von einem Audio-Codec (210) ausgegeben wird, der Audiosignale erzeugt, die durch einen Kondensator (220) an einen Lautsprecher geliefert werden, das die Schritte umfasst:
gleichmäßiges Laden des Kondensators (220), so dass er dasselbe Spannungsniveau wie die Vorspannung des Audio-Codecs (210) vor dem Aktivieren des Audio-Codecs (210) besitzt; und
Aktivieren des Audio-Codecs (210);
**dadurch gekennzeichnet, dass**
der Schritt des Ladens des Kondensators (220) umfasst
Erzeugen von Pulsdichtemodulations (PDM) - Pulssignalen mit einer Pulsdichte, die gemäß einer vorbestimmten Ladezeit vorbestimmt ist, durch einen Pulsgenerator, der von einer Steuereinheit (201) betrieben wird; und
Integrieren der PDM - Pulssignale durch eine Integrierschaltung (203), die zwischen dem Pulsgenerator (202) und dem genannten Schalter angeschlossen ist, um den genannten Kondensator (220) zu laden.

## Revendications

1. Un appareil pour éviter un bruit de crachement audio dû à une sortie de tension de polarisation de codeur-décodeur audio (210), comprenant :
un condensateur (220) connecté entre l'extrémité de la sortie du codeur-décodeur audio (210) et le haut-parleur ;
un chargeur de condensateur pour un chargement en douceur du condensateur (220) jusqu'à un niveau de tension prédéterminé ;
un commutateur disposé entre la jonction de l'extrémité de sortie du codeur-décodeur audio (210) et le condensateur (220) et le chargeur du condensateur ; et
une unité de commande (201) pour commander le codeur-décodeur audio (210), où l'unité de commande (201) enclenche le commutateur et actionne le chargeur de condensateur avant d'activer le codeur-décodeur audio (210), puis désenclenche le commutateur et termine l'opération du chargeur de condensateur si un laps de temps de chargement prédéterminé est écoulé ;
**caractérisé par le fait que**
le chargeur du condensateur comprend
un générateur d'impulsions (202) actionné par l'unité de commande (201) pour la génération de signaux d'impulsions de modulation de largeur d'impulsions (PWM - « Pulse Width Modulation ») ayant une largeur d'impulsion prédéterminée selon le laps de temps de chargement prédéterminé ; et
un circuit d'intégration (203) connecté entre le générateur d'impulsions (202) et le commutateur pour l'intégration des signaux d'impulsions PWM de manière à charger ledit condensateur (220).

2. Un appareil pour éviter un bruit de crachement audio dû à une sortie de tension de polarisation de codeur-décodeur audio (210), comprenant :
un condensateur (220) connecté entre l'extrémité de la sortie du codeur-décodeur audio (210) et le haut-parleur ;
un chargeur de condensateur pour le chargement en douceur du condensateur (220) jusqu'à un niveau de tension prédéterminé ;
un commutateur disposé entre la jonction de l'extrémité de la sortie du codeur-décodeur audio (210) et le condensateur (220) et le chargeur du condensateur ; et
une unité de commande (201) pour commander le codeur-décodeur audio (210), où l'unité de commande (201) enclenche le commutateur et actionne le chargeur de condensateur avant d'activer le codeur-décodeur audio (210), puis désenclenche le commutateur et termine l'opération du chargeur de condensateur si un laps de temps de chargement prédéterminé est écoulé ;
**caractérisé par le fait que**
le chargeur du condensateur comprend
un générateur d'impulsions (202) actionné par l'unité de commande (201) pour la génération de signaux d'impulsions de modulation de densité d' impulsions (PDM - « Pulse Density Modulation ») ayant une densité d'impulsions prédéterminée selon le laps de temps de chargement prédéterminé ; et
un circuit d'intégration (203) connecté entre le générateur d'impulsions (202) et ledit commutateur pour l'intégration des signaux d'impulsions PDM de manière à charger le condensateur (220).

3. Un appareil défini selon la revendication 1, où le laps de temps de chargement prédéterminé est le laps de temps de chargement du condensateur (220) jusqu'à un niveau de la tension de polarisation dudit codeur-décodeur audio (210).

4. Un procédé pour éviter un bruit de crachement audio dû à une sortie de tension de polarisation d'un codeur-décodeur audio (210) générant des signaux audio délivrés à travers un condensateur (220) à un haut-parleur, ledit procédé comprenant les étapes de:
chargement en douceur du condensateur (220) pour avoir le même niveau de tension que la tension de polarisation du codeur-décodeur audio (210) avant l'activation du codeur-décodeur audio (210) ; et
activation du codeur-décodeur audio (210) ;
**caractérisé par le fait que**
l'étape de chargement du condensateur (220) comprend
la génération de signaux d'impulsions de modulation de largeur d'impulsions (PWM-« Pulse Width Modulation ») ayant une largeur d'impulsions prédéterminée selon le laps de temps de chargement prédéterminé par un générateur d'impulsions (202) actionné par l'unité de commande (201) ; et
l'intégration des signaux d'impulsions PWM par un circuit d'intégration (203), de manière à charger ledit condensateur (220).

5. Un procédé pour éviter un bruit de crachement audio dû à une sortie de tension de polarisation d'un codeur-décodeur (210) générant des signaux audio délivrés à travers un condensateur (220) au haut-parleur, ledit procédé comprenant les étapes de :
chargement en douceur du condensateur (220) pour avoir le même niveau de tension que la tension de polarisation du codeur-décodeur audio (210) avant d'activer le codeur-décodeur audio (210) ; et
activation du codeur-décodeur audio (210) ;
**caractérisé par le fait que**
l'étape de chargement du condensateur (220) comprend
la génération de signaux d'impulsions de modulation de densité d'impulsions (PDM - « Pulse Density Modulation ») ayant une densité d'impulsions prédéterminée selon le laps de temps de chargement prédéterminé par un générateur d'impulsions (202) actionné par l'unité de commande (201) ; et
l'intégration des signaux d'impulsions PDM par un circuit d'intégration (203) connecté entre le générateur d'impulsions (202) et ledit commutateur de manière à charger le condensateur (220).
